# EUROPÄISCHE PATENTSCHRIFT

(11) **EP 2 197 787 B1**
(45) Veröffentlichungstag und Bekanntmachung des Hinweises auf die Patenterteilung: **01.08.2012**
(21) Anmeldenummer: 08804536.4
(22) Anmeldetag: 22.09.2008
(51) Int. Cl.: C01B 33/035

(54) **POLYKRISTALLINES SILICIUM UND VERFAHREN ZU SEINER HERSTELLUNG**
POLYCRYSTALLINE SILICON AND METHOD FOR THE PRODUCTION THEREOF
SILICIUM POLYCRISTALLIN ET SON PROCÉDÉ DE PRODUCTION

(30) Priorität: 02.10.2007 DE 102007047210
(43) Veröffentlichungstag der Anmeldung: 23.06.2010
(73) Patentinhaber: Wacker Chemie AG, 81737 München (DE)
(72) Erfinder: HERTLEIN, Harald, 84489 Burghausen (DE); KRÄTZSCHMAR, Oliver, 84508 Burgkirchen (DE)
(74) Vertreter: Potten, Holger
(86) Internationale Anmeldenummer: PCT/EP2008/062610
(87) Internationale Veröffentlichungsnummer: WO 2009/047107

(56) Entgegenhaltungen:
- EP-A1- 0 976 457
- JP-A- 5 004 811
- JP-A- 2006 240 934
- US-A1- 2003 150 378
- SEMI, 3081 ZANKER ROAD, SAN JOSE, CA 95134, USA, 1. September 2004 (2004-09-01) , XP040454068

## Beschreibung

Die Erfindung betrifft polykristallines Silicium für Halbleiter- und Photovoltaik-Anwendungen und ein Verfahren zu seiner Herstellung.

Polykristallines Silicium (Polysilicium) dient als Ausgangsmaterial zur Herstellung von einkristallinem Silicium für Halbleiter nach dem Czochralski(CZ)- oder Zonenschmelz(FZ)-Verfahren, sowie zur Herstellung von ein- oder multikristallinem Silicium nach verschiedenen Zieh- und GießVerfahren zur Produktion von Solarzellen für die Photovoltaik. Es wird in der Regel mittels des Siemens-Verfahrens hergestellt. Bei diesem Verfahren werden in einem glockenförmigen Reaktor ("Siemens-Reaktor") dünne Filamentstäbe aus Silicium durch direkten Stromdurchgang erhitzt und ein Reaktionsgas enthaltend eine siliciumhaltige Komponente und Wasserstoff wird eingeleitet. Die siliciumhaltige Komponente des Reaktionsgases ist in der Regel Monosilan oder ein Halogensilan der allgemeinen Zusammensetzung SiHₙX**₄₋ₙ** (n=0, 1, 2, 3; X=Cl, Br, I). Bevorzugt handelt es sich um ein Chlorsilan (X=Cl), besonders bevorzugt um Trichlorsilan (n=1). Überwiegend wird SiH₄ oder SiHCl₃ im Gemisch mit Wasserstoff eingesetzt. Die Filamentstäbe stecken senkrecht in am Reaktorboden befindlichen Elektroden, über die der Anschluss an die Stromversorgung erfolgt. An den erhitzten Filamentstäben und der waagrechten Brücke scheidet sich hochreines Polysilicium ab, wodurch der Stabdurchmesser mit der Zeit anwächst.

Das Verfahren wird durch die Vorgabe von Stabtemperatur und Reaktionsgasstrom bzw. -zusammensetzung gesteuert. Die Messung der Stabtemperatur erfolgt mit Strahlungspyrometern an den Oberflächen der senkrechten Stäbe. Die Stabtemperatur wird durch Steuerung oder Regelung der elektrischen Leistung entweder fest oder in Abhängigkeit vom Stabdurchmesser vorgegeben. Die Reaktionsgasmenge wird in Abhängigkeit vom Stabdurchmesser vorgegeben. Die Abscheidebedingungen werden dabei so gewählt, dass das Wachstum des Stabdurchmessers in Form gleichmäßiger und lochfreier Schichten erfolgt, d.h. die so erzeugten Siliciumstäbe sind weitestgehend frei von Rissen, Poren, Fugen, Klüften, usw. und damit homogen, dicht und fest. Ein derartiges Material und seine Bearbeitung wird beispielsweise in US6350313B2 beschrieben. Die Rohdichte eines derartigen kompakten Polysiliciums entspricht der Reindichte von Polysilicium und liegt bei 2,329 g/cm³.

Die so erhaltenen Polysiliciumstäbe müssen zu Brocken und Chips verarbeitet werden, wenn sie nicht für die Herstellung von Einkristallen nach dem FZ-Verfahren Verwendung finden. Dazu werden die Stäbe mit Werkzeugen, wie Hämmern, Brechern oder Mühlen zerkleinert und anschließend nach Größe klassiert. Dabei wird das Polysilicium durch die Werkzeuge umso stärker verunreinigt, je geringer die Bruchgröße ist und je höher die Festigkeit der Polysiliciumstäbe ist.

Für die Herstellung von ein- und multikristallinem Silicium werden Tiegel mit Bruchstücken unterschiedlicher Größe gefüllt. Für die Erstbefüllung wird ein möglichst hoher Füllgrad der Tiegel angestrebt. Hierfür müssen Siliciumstücke von sehr unterschiedlicher Größe und Gewicht, d.h. gesägte Stabstücke, grobe Brocken, kleine Chips und feines Material gemischt werden. Die Größe der Siliciumstücke reicht dabei von < 1 mm bis zu Stücken von 150 mm und mehr, die Form der Stücke darf nicht zu stark von der Kugelform abweichen.

Für das mehrfache Wiederbefüllen der Tiegel eignen sich nur feinkörnige, rieselfähige, d.h. möglichst kugelförmige Bruchstücke, da das Material durch Rohre und Armaturen in den Tiegel gefördert werden muss und weder den Tiegel beschädigen, noch die Siliciumschmelze übermäßig stören darf.

Die Ausbeute der Tiegelziehprozesse wird begrenzt durch die Menge der sich in der Si-Schmelze anreichernden Verunreinigungen, die wiederum überwiegend durch die feinkörnigen Siliciumbruchstücke eingetragen werden.

Da der Kristallziehprozess empfindlich auf Größenverteilung und Form des eingesetzten Polysiliciums reagiert, hat sich ein Verhältnis von Breite zu Länge (B/L) der Siliciumbruchstücke von 0,7 bis 1,0, sowie eine Sphärizität der Siliciumbruchstücke von 0,7 bis 1,0 als ein de facto-Standard für den Einsatz in Kristallziehprozessen etabliert. Ein Beispiel für die am Weltmarkt üblichen unterschiedlichen Bruchgrößenbereiche zur gezielten Tiegeleinrichtung mit möglichst hohem Tiegelfüllgrad findet sich z. B. auf der folgenden Internetseite der Wacker Chemie AG, auf der Bruchgrößenfraktionen mit einer maximalen Länge der Siliciumbruchstücke von 5 - 45 mm, 20 - 65 mm, 20 - 150 mm angeboten werden: (http://www.wacker.com/internet/webcache/en_US/PTM/Polysilicon /PolyChunks/Polysilicon_chunks_etched.pdf).

Die Länge L bezeichnet die maximale Ausdehnung eines Teilchens, die Breite B ist die zur maximalen Ausdehnung senkrechte Abmessung. Die Sphärizität ist definiert als Durchmesser des projektionsflächengleichen Kreises eines Teilchens geteilt durch den Durchmesser eines Kreises, der die Teilchenprojektion umschließt (Definition nach Wadell für zweidimensionale Messräume).

Aus US 2003/0150378 A2 ist so genanntes "Teardrop-Poly" und ein Verfahren zu seiner Herstellung bekannt. Bei diesem Verfahren wird aus Monosilan SiH₄ mittels des Siemens-Verfahrens bis zu einem Siliciumstabdurchmesser von 45 mm bei 850 und °C. einer Silankonzentration von 1,14 mol% ein kompakter, lochfreier hochreiner Polysiliciumstab ("Stamm") abgeschieden. Anschließend wird die Staboberflächentemperatur sprungartig von 850 auf 988°C erhöht und die Silankonzentration sprungartig von 1,14 auf 0,15 mol% reduziert. Durch diesen Parametersprung ändert sich das Wachstum der Siliciumkristalle auf dem Siliciumstab schlagartig und es wachsen Nadeln, so genannte Dendriten, aus der Staboberfläche heraus. Anschließend wird die Staboberflächentemperatur kontinuierlich abgesenkt, so dass bis zum Ende der Abscheidung das Weiterwachsen der Nadeln zu großen tropfenförmigen "Teardrops" fortgeführt wird. Die "Teardrops" sind tropfenförmige Gebilde, die nur mit ihrem spitzen Ende mit dem Stamm verbunden und nicht miteinander verwachsen sind. Dies ermöglicht bei der Herstellung von Siliciumbruch ein leichtes Abbrechen der Teardrops vom "Stamm". Dieses Polysilicium und das Verfahren zu seiner Herstellung weisen eine Reihe von Nachteilen auf: Der Polysiliciumstab ist sehr inhomogen. Er besteht aus einem kompakten, riss- und kluftfreien und damit festen "Stamm" und den durch Hohlräume voneinander getrennten und nicht miteinander verwachsenen "Teardrops". Nachdem die "Teardrops" abgetrennt wurden, muss der Stamm separat weiter verarbeitet werden. Dies bedeutet zusätzlichen Aufwand in Form eines zweistufigen Prozesses, ggf. sogar mit einer Zwischenlagerung von Material.

Die relativen Massen-Anteile von Stamm und Teardrops werden durch den Abscheideprozess festgelegt. Im Gegensatz zu einem einheitlichen Material kann die Größeverteilung des zerkleinerten Materials deshalb nicht mehr frei gewählt werden. Aufgrund der fehlenden Verbindung zwischen den Teardrops erfolgt der Stromfluss ausschließlich durch den Stamm. Dessen Durchmesser kann daher nicht beliebig gering gewählt werden, da er sonst schmelzen würde. Da die benötigten Stromstärken bei der Abscheidung mit steigendem Durchmesser zunehmen, bedeutet dies, dass auch der Durchmesser des Stamms zunehmen muss. Damit steht nur ein mit steigendem Stabdurchmesser abnehmender Anteil des abgeschiedenen Siliciums als Teardrops zur Verfügung.

Die Form der Teardrops weicht in Größenverteilung, Sphärizität und B/L-Verhältnis stark von dem aus kompakten Siliciumstäben erhaltenen Bruch ab. Dieses Material ist deshalb nicht ohne Anpassung der Silicium-Ziehprozesse zur Herstellung von ein- oder polykristallinem Silicium einsetzbar.

Aufgabe der Erfindung ist es, einen polykristallinen Siliciumstab zur Verfügung zu stellen, welcher für einen Einsatz in der Halbleitertechnik und insbesondere in der Photovoltaik besonders geeignet ist.

Die Aufgabe wird gelöst durch einen polykristallinen Siliciumstab, der dadurch gekennzeichnet ist, dass er einen Stabquerschnitt mit einem zur elektrischen Leitung zur Verfügung stehenden Flächenanteil von 50 - 99 % an Silicium besitzt und der Stab eine Biegefestigkeit von 0,1 bis 80 N/mm² aufweist.

Vorzugsweise besitzt der Stabquerschnitt eine zur elektrischen Leitung zur Verfügung stehenden Flächenanteil von 80 % - 99 % und ganz besonders bevorzugt eine zur elektrischen Leitung zur Verfügung stehenden Flächenanteil von 90 % - 99 % an Silicium. Der Rest des Stabquerschnitts wird durch Risse und Poren gebildet. Die elektrische Leitfähigkeit des Siliciumstabes wird durch die kleinen Risse und Poren im Vergleich zu herkömmlichem kompaktem Polysilicium kaum beeinträchtigt.

Vorzugsweise wird der Stabquerschnitt senkrecht zur Längsachse des Stabs bestimmt. Der Flächenanteil an Silicium und der Flächenanteil an Rissen, Poren und Fugen lässt sich mit handelsüblichen optischen Bildanalysen ermitteln.

Vorzugsweise beträgt die Biegefestigkeit 0,1 bis 16 N/mm², besonders bevorzugt 0,5 bis 2 N/mm² und insbesondere bevorzugt von 0,5 bis kleiner 1,6 N/mm²

Bevorzugt hat der Stab zudem eine Druckfestigkeit von 1 bis 100 N/mm², besonders bevorzugt 20 bis 60 N/mm², Insbesondere bevorzugt beträgt die Druckfestigkeit 58 N/mm².

Bevorzugt hat der Stab zudem eine Rohdichte von 2,0 bis 2,3 g/cm³. Insbesondere bevorzugt eine Rohdichte von 2,25 bis 2,3 g/cm³. Die Rohdichte ist definiert als die Dichte des Polysiliciums einschließlich des Porenraums im trockenen Zustand nach DIN-EN 1936 (Wägung volumenmäßig definierter Prüfkörper oder Messung des Auftriebs der gesättigten Probe in Quecksilber mit einer hydrostatischen Waage).

Bevorzugt hat das abgeschiedene Polysilicium eine Gesamtporosität von 0,01 bis 0,2 ganz besonders bevorzugt von 0,023. Die Gesamtporosität einer Probe setzt sich zusammen aus der Summe der Hohlräume, die untereinander und mit der Umgebung in Verbindung stehen und den nicht miteinander verbundenen Hohlräumen. Die Gesamtporosität, d.h. der Anteil des Gesamtporenvolumens (offene und geschlossene Poren) am Gesamtvolumen des Polysiliciums wird ermittelt nach DIN-EN 1936 aus der Berechnung aus Roh- und Reindichte, d.h. Gesamtporosität = 1 - (Rohdichte/2,329[g/cm³]).

Die Biegefestigkeit wird gemäß DIN 51902 bestimmt. Die Druckfestigkeit wird gemäß DIN 51910 bestimmt. Die Biegefestigkeit des erfindungsgemäßen Polystabs liegt damit 2-3 Größenordnungen unter dem Wert von kompaktem Polysilicium, an dem 160 N/mm² gemessen wurden. Auch die Druckfestigkeit des erfindungsgemäßen Polystabs ist erheblich niedriger als die Druckfestigkeit von kompaktem Polysilicium, welches eine Druckfestigkeit von ca. 170 N/mm² aufweist.

Bei einem erfindungsgemäßen Polysiliciumstab weist die im Siemensprozess aufgewachsene Siliciumschicht eine über den Stabradius gleichartige Struktur auf, wobei diese Struktur Poren, Fugen, Spalten, Risse und Klüfte enthält und die verringerte Festigkeit des Polysiliciums bewirkt, aber den Stromfluss durch den Stab nicht limitiert.

Erreicht werden diese Eigenschaften des erfindungsgemäßen Polysiliciumstabes durch eine Verfahrensführung im Abscheideverfahren, die zu Poren, Fugen, Spalten, Rissen und Klüften im abgeschiedenen Silicium führt, wobei diese Poren, Fugen, Spalten, Risse und Klüfte eine derart geringe Größe haben, dass sie den Stromfluss nicht behindern. Damit erfolgt im erfindungsgemäßen Stab der Stromfluss wie bei herkömmlichen Polysiliciumstäben über den gesamten Stabquerschnitt und die für Teardrop-Poly beschriebenen Nachteile, insbesondere eine Durchmesserbeschränkung des Stabs, treten nicht auf.

Der erfindungsgemäße Polysiliciumstab kann wie ein bekannter kompakter Polysiliciumstab zerkleinert werden. Er liefert die gleiche Bruchgrößenverteilung, gleiche Sphärizität und gleiches Breite/Länge-Verhältnis der Bruchstücke wie ein bekannter kompakter Polysiliciumstab. Vorteilhafterweise lässt sich ein erfindungsgemäßer Polysiliciumstab aufgrund seiner geringen Festigkeit allerdings mit einem weitaus geringeren Energieaufwand zerkleinern, als ein herkömmlicher Polysiliciumstab. Der resultierende Polysilicium-Bruch weist deshalb eine geringere Oberflächenkontamination auf, als üblicher ungereinigter Polysilicium-Bruch. Eine anschließende Reinigung des Polysilicium-Bruchs ist daher in vielen Fällen unnötig und die Herstellkosten von Bruchstücken aus polykristallinem Silicium werden dadurch weiter gesenkt.

Der erfindungsgemäße Polysiliciumstab ermöglicht somit eine kostengünstige und kontaminationsarme Herstellung eines Polybruchs einer Größe, eines Breite/Länge-Verhältnisses und einer Sphärizität im beim Kristallziehen in der Vergangenheit bereits standardmäßig eingesetzten Bereich.

Die Erfindung betrifft daher auch hochreine Bruchstücke aus polykristallinem Silicium einer Größe von 1 bis 150 mm, die aus einem erfindungsgemäßen Polysiliciumstab ohne Nachreinigung hergestellt werden können. Diese Bruchstücke haben eine Bruchgrößenverteilung von 1 bis 150 mm, ein Breite/Länge-Verhältnis von 0,7 bis 1, eine Sphärizität im Bereich 0,7 bis 1 und sind dadurch gekennzeichnet, dass sie eine Oberfläche mit einer Summe an metallischen Verunreinigungen zwischen 1 und 12 ppbw haben und die Oberfläche weniger als 62 ppb Nitrat- und weniger als 1 ppb Fluorid-Verbindungen aufweist.

Die metallischen Verunreinigungen an der Oberfläche werden mit ICPMS nach ASTM F 1724-96 bestimmt. Die Fluorid-und Nitrat-Verunreinigungen werden mittels der Kapillarzonenelektrophorese bestimmt, wie im Semidraft Document 3083, Semiconductor Equipment and Materials international, 805 East Middlefield Road, Mountain View, CA 84043-4080, Document Number: 3083, Revision N/A, Date 22.07.1999, beschrieben.

Eine weitere Aufgabe der Erfindung ist es ein Verfahren zur Verfügung zu stellen, welches es ermöglicht, einen erfindungsgemäßen polykristallinen Siliciumstab herzustellen.

Dieses Verfahren, bei dem ein Mengenstrom eines Reaktionsgases enthaltend ein Chlorsilangemisch und Wasserstoff in einen Reaktor eingeleitet wird und hochreines Polysilicium an einem durch direkten Stromdurchgang erhitzten Filamentstab aus Silicium abgeschieden wird, wobei der Filamentstab aus zwei senkrechten und einem waagrechten Stab gebildet wird und wobei der waagrechte Stab eine verbindende Brücke zwischen den senkrechten Stäben bildet, ist dadurch gekennzeichnet, dass als Chlorsilangemisch ein Gemisch aus Di- und Trichlorsilan eingesetzt wird und der Stromdurchgang durch den Filamentstab derart geregelt ist, dass der Filamentstab eine Temperatur an der Unterseite der Brücke zwischen 1300 und 1413°C aufweist und die Temperatur der Reaktionsgase im Reaktor gemessen und so eingestellt wird, dass sie höchstens 650°C beträgt, und der Mengenstrom des Chlorsilangemisches in weniger als 30 Stunden, bevorzugt in weniger als 5 Stunden ab Beginn der Zufuhr des Chlorsilangemisches auf seinen Maximalwert eingestellt wird.

Im folgenden wird die Temperatur an der Unterseite der Brücke Brückentemperatur und die Temperatur der Gase im Reaktor Gastemperatur genannt.

Der Dichlorsilangehalt im Chlorsilangemisch liegt im Bereich 1 bis 15 Gewichtsprozent, bevorzugt 3 bis 10 Gewichtsprozent.

Im Unterschied zu herkömmlichen Verfahren wird der Mengenstrom des Chlorsilangemisches erfindungsgemäß nicht dem zunehmenden Stabdurchmesser proportional erhöht, sondern der Maximalwert erheblich schneller eingestellt. Der Maximalwert des Mengenstroms des Chlorsilangemisches ist vorzugsweise 350 - 1000 kg/h Chlorsilan pro m² Siliciumstaboberfläche ganz besonders bevorzugt größer 460 kg/(h-m²) bis 1000 kg/(h·m²).

Anders als der Stand der Technik berücksichtigt das erfindungsgemäße Verfahren zudem die Gastemperatur im Reaktor. Diese wird vorzugsweise mit einer Messeinrichtung, beispielsweise mit einem Temperatursensor (z. B. einem Thermoelement) im Reaktor oder besonders bevorzugt am Gasaustritt gemessen. Diese wird auf maximal 650°C begrenzt. Vorzugsweise beträgt sie 400 bis 650°C.

Die Chlorsilankonzentration im siliciumhaltigen Reaktionsgas ist beim erfindungsgemäßen Verfahren vom Beginn des Verfahrens bis zum Erreichen einer Gastemperatur von 650°C auf einem konstant hohen Wert von 22 bis 30, bevorzugt 25 bis 28 mol% Chlorsilan. Die Chlorsilankonzentration wird ab einer Gastemperatur von 650°C durch Zugabe von Wasserstoff bis zum Ende der Abscheidung auf einen niedrigeren Wert von 15 bis 25 bevorzugt 19 bis 22 mol% abgesenkt. Die Einstellung der Chlorsilankonzentration im Reaktor erfolgt durch eine Variation der Menge an Wasserstoff im Reaktionsgasgemisch. Auch die Regelung der Gastemperatur im Reaktor erfolgt vorzugsweise über die Variation der Menge an Wasserstoff im Reaktionsgasgemisch.

Es ist ferner erfindungswesentlich, die Stabtemperatur an der Unterseite der Brücke und damit an der heißesten Stelle des Stabs zu bestimmen. Um mit möglichst maximaler Abscheidetemperatur über die gesamte Abscheidephase zu arbeiten, wie es im erfindungsgemäßen Verfahren bevorzugt ist, gibt es zu dieser Form der Temperaturmessung keine Alternative, da der Zusammenhang zwischen Brückentemperatur und Oberfläche der senkrechten Stäbe von vielen Prozessparametern abhängig ist und sich somit bei einer Änderung der Stabdicke, Gasmenge, mol%, Reaktorgeometrie, Anlagendrücke bei gleicher Temperatur an der Unterseite der Brücke unterschiedliche Temperaturen an der Oberfläche der senkrechten Stäbe einstellen. Die Temperatur der senkrechten Stäbe variiert ferner stärker in Abhängigkeit von dem Gasströmungsbedingungen und den Gasmengen als die Temperatur der Brücke.

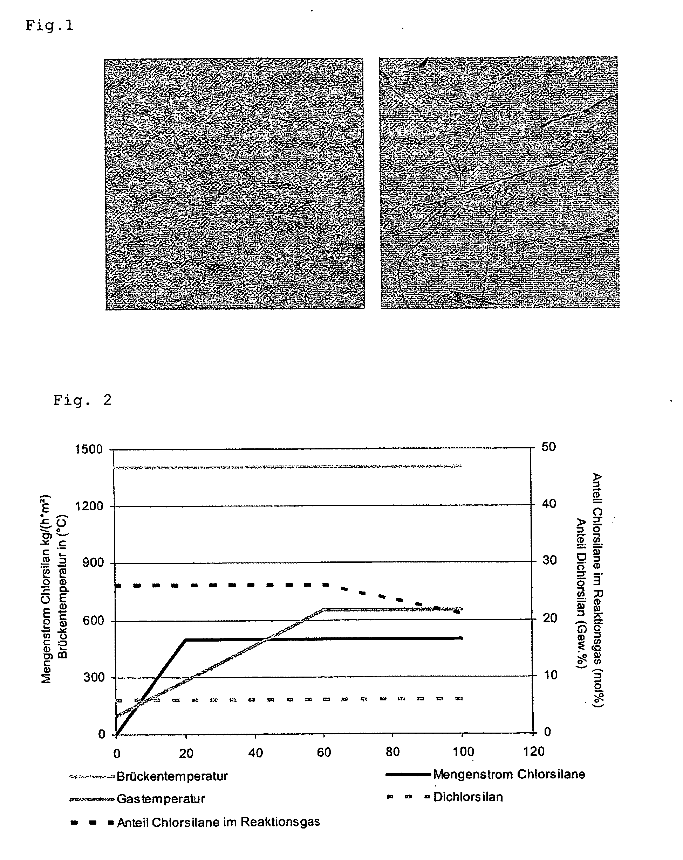

Durch die beschriebene Kombination von Brückentemperatur, schneller Maximierung der Chlorsilanzugabemenge, Dichlorsilananteil im Chlorsilangemisch, Gastemperatur und Molverhältnis Chlorsilan/Wasserstoff bzw. Anteil Chlorsilan im Reaktionsgas werden die erfindungsgemäßen brüchigen Polysiliciumstäbe erhalten. Eine bevorzugte Form der Verfahrensführung ist in Fig. 2 zusammenfassend dargestellt.

Das erfindungsgemäße Verfahren benötigt nur noch einen spezifischen Energiebedarf von kleiner 40 kWh pro kg Polysilicium und erreicht Abscheidegeschwindigkeiten von deutlich über 1,6 mm Silicium/h. Demgegenüber haben Siemens-Abscheideverfahren gemäß Stand der Technik einen spezifischen Energiebedarf von 80 bis 100 kWh/kg und erreichen eine Abscheidegeschwindigkeit von 1 bis 1,5 mm/h (Handbook of Semiconductor Silicon Technology, William C. O'Mara, Robert B. Herring,and Lee P. Hunt, Noyes Publications, Park Ridge, New Jersey, USA, 1990, Seite 77).

Fig.1 zeigt je eine Oberfläche eines Würfels einer Kantenlänge von 50 mm aus polykristallinem Silicium, herausgesägt aus einem Polysiliciumstab, hergestellt mittels Siemens Verfahren gemäß Vergleichsbeispiel 1 (linkes Bild) bzw. hergestellt aus einem Polysiliciumstab gemäß Beispiel 1 (rechtes Bild).

Fig. 2 zeigt den zeitlichen Verlauf (X-Achse: Zeit in h) der Prozessparameter Brückentemperatur (°C), Gastemperatur (°C), Molanteil Chlorsilan im Reaktionsgas (mol%), spezifischer Mengenstrom Chlorsilane (kg/(h·m²)), sowie Dichlorsilananteil (Gew.%) im Chlorsilangemisch, bei der Durchführung einer Ausführungsform des erfindungsgemäßen Verfahrens.

Die folgenden Beispiele dienen der weiteren Erläuterung der Erfindung.

### Beispiel 1: Herstellung eines erfindungsgemäßen Polysiliciumstabs

In einem Siemensreaktor wurde ein erfindungsgemäßer Polysiliciumstab durch Abscheidung von Silicium aus einem Reaktionsgas bestehend aus einem Chlorsilangemisch und Wasserstoff auf einem erhitzten Si-Dünnstab hergestellt. Das Chlorsilangemisch bestand aus 94 Gewichtsprozent Trichlorsilan und 6 Gewichtsprozent Dichlorsilan. Die Mengenströme von Chlorsilangemisch und Wasserstoff wurden unabhängig voneinander geregelt. Der Chlorsilanstrom wurde innerhalb von 15 Stunden ab Beginn der Abscheidung auf 460 kg Chlorsilan pro h und m² Siliciumoberfläche(kg/(h·m²)) gesteigert und anschließend über die restliche Chargenlaufzeit konstant gehalten.

Die Gastemperatur wurde mit einem Temperaturfühler am Gasaustritt aus dem Reaktor gemessen. Der Wasserstoffstrom wurde bis zu einer Gastemperatur von 650°C proportional zum Chlorsilanstrom gesteigert, so dass der Molanteil an Chlorsilan im Reaktionsgas konstant bei 26 mol% lag, danach wurde er erfindungsgemäß so eingestellt, dass die Gastemperatur nicht weiter steigt, d.h. auf 650°C begrenzt blieb.

Die Temperatur des Si-Stabes wurde an der Unterseite der Brücke mit einem Strahlungspyrometer gemessen und während der gesamten Chargenlaufzeit konstant bei 1400°C gehalten.

Die Abscheidung wurde bei einem Durchmesser des Polysiliciumstabes von 150 mm beendet. Die so hergestellten Polysiliciumstäbe hatten folgende Eigenschaften:
Flächenanteil Silicium zur elektrischen Leitung: 97 % Gesamtporosität des abgeschiedenen Polysilicium von 0,023 Rohdichte: 2,275 g/cm³
Druckfestigkeit (gemessen nach DIN 51910): 58 N /mm²
Biegefestigkeit (gemessen nach DIN 51902) 1,6 N/mm²

### Vergleichsbeispiel 1: Herstellung eines Polysiliciumstabs aus "kompaktem Silicium"

In einem Siemensreaktor wurde ein kompakter Polysiliciumstab durch Abscheidung von Silicium mit einem Reaktionsgas bestehend aus einem Chlorsilangemisch und Wasserstoff auf einem erhitzten Si-Dünnstab hergestellt. Das Chlorsilangemisch bestand aus 100 Gewichtsprozent Trichlorsilan.

Die Mengenströme von Chlorsilangemisch und Wasserstoff wurden unabhängig voneinander geregelt. Der Chlorsilanstrom wurde innerhalb von 30 Stunden ab Beginn der Abscheidung auf 350 kg Chlorsilan pro h und m² Siliciumoberfläche(kg/(h·m²)) gesteigert und anschließend über die restliche Chargenlaufzeit konstant gehalten. Die Gastemperatur wurde mit einem Temperaturfühler am Gasaustritt gemessen und betrug maximal 500°C. Der Wasserstoffstrom wurde proportional zum Chlorsilanstrom gesteigert, so dass der Molanteil an Chlorsilan konstant bei 20 mol% lag. Die Temperatur des Si-Stabes wurde an der Oberfläche eines senkrechten Stabes mit einem Strahlungspyrometer gemessen und während der gesamten Chargenlaufzeit konstant bei 1030°C gehalten.

Die Abscheidung wurde bei einem Durchmesser des Polysiliciumstabes von 150 mm beendet. Die so hergestellten Polysiliciumstäbe hatten folgende Eigenschaften:
Flächenanteil Silicium zur elektrischen Leitung: 100 % Gesamtporosität des abgeschiedenen Polysilicium von 0 (d.h. nicht porös sondern kompakt ohne Poren, Löcher, Fugen.) Rohdichte gleich Reindichte: 2,329 g/cm³
Druckfestigkeit (gemessen nach DIN 51910): 170 N/mm²
Biegefestigkeit (gemessen nach DIN 51902): 160 N/mm²

### Vergleichsbeispiel 2 Herstellung eines Polysiliciumstabs aus "kompaktem Silicium"

In einem Siemensreaktor wird ein kompakter Polysiliciumstab wie im Handbook of Semiconductor Silicon Technology, 1990, Seite 1 bis 81 beschrieben hergestellt.

Dazu wurde Silicium mit einem Reaktionsgas bestehend aus einem Chlorsilangemisch und Wasserstoff auf einem erhitzten Si-Dünnstab abgeschieden. Das Chlorsilangemisch bestand aus 100 Gewichtsprozent Trichlorsilan.

Die Gastemperatur wurde mit einem Temperaturfühler am Gasaustritt gemessen und betrug maximal 575°C. Der Wasserstoffstrom wurde proportional zum Chlorsilanstrom gesteigert, so dass der Molanteil an Chlorsilan bei 10 mol% lag.

Die Temperatur des Si-Stabes wurde an der Oberfläche eines senkrechten Stabes mit einem Strahlungspyrometer gemessen und während der gesamten Chargenlaufzeit konstant bei 1030°C gehalten. Der Energiebedarf lag bei 90 kWh /kg Silicium und die Abscheidegeschwindigkeit bei 1,2 mm/h.

Die Abscheidung wurde bei einem Durchmesser des Polysiliciumstabes von 150 mm beendet. Die so hergestellten Polysiliciumstäbe hatten folgende Eigenschaften:
Flächenanteil Silicium zur elektrischen Leitung: 100 % Gesamtporosität des abgeschiedenen Polysilicium von 0 (d.h. nicht porös sondern kompakt ohne Poren, Löcher, Fugen.) Rohdichte gleich Reindichte: 2,329 g/cm³
Druckfestigkeit (gemessen nach DIN 51910): 170 N/mm²
Biegefestigkeit (gemessen nach DIN 51902): 160 N/mm²

### Beispiel 2 Herstellung Polybruch

Je ein Polysiliciumstab aus Beispiel 1, Vergleichsbeispiel 1 und 2 wurde mit einem Wolframcarbid-Hammer zerkleinert. Die entstehenden Bruchstücke hatten ein B/L-Verhältnis und eine

Sphärizität im Bereich 0,7 bis 1 und eine gleiche Bruchgrößenverteilung im Bereich 1 bis 150 mm. Sie entsprachen damit der üblichen Spezifikation von Polybruch, wie sie zur Weiterverarbeitung unabdingbar ist.

Die Bruchgrößenverteilung des zerkleinerten Polystabes aus Beispiel 1 hatte einen Massenanteil von 77 % im Bruchgrößenbereich 20 - 150 mm, 11 % im Bereich 20 - 65 mm, 8 % im Bereich 5 - 45 mm und 4 % im Bereich kleiner 15 mm.

Die Bruchgrößenverteilung des zerkleinerten Polystabes aus Vergleichsbeispiel 1 hatte einen Massenanteil von 74 % im Bruchgrößenbereich 20 - 150 mm, 12 % im Bereich 20 - 65 mm, 9 % im Bereich 5 - 45 mm und 5 % im Bereich kleiner 15 mm. Die Bruchgrößenverteilung des zerkleinerten Polystabes aus Vergleichsbeispiel 2 hatte einen Massenanteil von 79 % im Bruchgrößenbereich 20 - 150 mm, 10 % im Bereich 20 - 65 mm, 7 % im Bereich 5 - 45 mm und 4 % im Bereich kleiner 15 mm.

Die Summe der metallischen Oberflächenverunreinigungen lag bei den erfindungsgemäßen Bruchstücken zwischen 1 und 12 ppbw und die Verunreinigung der Oberfläche durch Anionen bestimmt mit Hilfe der Kapillarzonenelektrophorese lag bei kleiner 62 ppb Nitrat und 1 ppb Fluorid.

Durch die höhere Festigkeit der kompakten Siliciumstäbe der Vergleichsbeispiele war der mechanische Aufwand und der Energieaufwand zur Zerkleinerung dieser Polysiliciumstäbe deutlich größer. Durch den höheren mechanischen Aufwand kommt es zu einer höheren Oberflächenverunreinigung der daraus hergestellten Bruchstücke.

Die Verunreinigung der Bruchstücke der Vergleichsbeispiele lag daher deutlich höher.

Die Summe der metallischen Oberflächenverunreinigungen lag bei über 100 ppbw. Diese Bruchstücke können nicht ohne zusätzlichen Reinigungsschritt in der Halbleiter- oder Photovoltaikindustrie eingesetzt werden.

Um die Bruchstücke in der Halbleiter und Photovoltaikindustrie einsetzen zu können, werden die Bruchstücke in Säurebädern wie im Stand der Technik z.B. US 6309467 beschrieben, gereinigt. Dadurch kommt es zu einer Verunreinigung der Polysiliciumbruch - Oberfläche durch Anionen. Bestimmt mit Hilfe der Kapillarzonenelektrophorese liegen die Anionen-Werte nach einer Reinigung bei größer 62 ppb Nitrat und 1 ppb Fluorid.

## Patentansprüche

1. Polykristalliner Siliciumstab, **dadurch gekennzeichnet, dass** er einen Stabquerschnitt mit einem zur elektrischen Leitung zur Verfügung stehenden Flächenanteil von 50 - 99 % an Silicium besitzt und der Stab eine Biegefestigkeit von 0,1 bis 80 N/mm² aufweist.

2. Siliciumstab gemäß Anspruch 1, **dadurch gekennzeichnet, dass** er eine Druckfestigkeit von 1 bis 100 N/mm² und eine Rohdichte im Bereich 2,0 bis 2,3 g/cm³ und eine Gesamtporosität von 0,01 bis 0,2 hat.

3. Siliciumstab gemäß Anspruch 1 oder 2, **dadurch gekennzeichnet, dass** er eine im Siemensprozess aufgewachsene Siliciumschicht mit einer gleichartigen Struktur aufweist, wobei diese Struktur Poren, Fugen, Spalten, Risse und Klüfte enthält.

4. Polysiliciumbruch, hergestellt aus einem Siliciumstab gemäß Anspruch 1, 2 oder 3, mit einer Bruchgrößenverteilung von 1 bis 150 mm und einer Sphärizität von 0,7 bis 1,0 und einem Breiten zu Längenverhältnis im Bereich 0,7 bis 1,0, **dadurch gekennzeichnet, dass** er eine Oberfläche mit einer Summe an metallischen Verunreinigungen zwischen 1 und 12 ppbw hat und die Oberfläche, weniger als 62 ppb Nitrat und weniger als 1 ppb Fluorid aufweist.

5. Verfahren zur Herstellung eines Polysiliciumstabs nach einem der Ansprüche 1 bis 3, bei dem ein Mengenstrom eines Reaktionsgases enthaltend ein Chlorsilangemisch und Wasserstoff in einen Reaktor eingeleitet wird und hochreines Polysilicium an einem durch direkten Stromdurchgang erhitzten Filamentstab aus Silicium abgeschieden wird, wobei der Filamentstab aus zwei senkrechten und einem waagrechten Stab gebildet wird und wobei der waagrechte Stab eine verbindende Brücke zwischen den senkrechten Stäben bildet, **dadurch gekennzeichnet, dass** als Chlorsilangemisch ein Gemisch aus Di- und Trichlorsilan eingesetzt wird und der Stromdurchgang durch den Filamentstab derart geregelt ist, dass der Filamentstab eine Temperatur an der Unterseite der Brücke zwischen 1300 und 1413°C aufweist und die Temperatur der Reaktionsgase im Reaktor gemessen und so eingestellt wird, dass sie höchstens 650°C beträgt, und der Mengenstrom des Chlorsilangemisches in weniger als 30 Stunden, bevorzugt in weniger als 5 Stunden ab Beginn der Zufuhr des Chlorsilangemisches auf seinen Maximalwert eingestellt wird.

6. Verfahren gemäß Anspruch 5, **dadurch gekennzeichnet, dass** die Temperatur an der Unterseite der Brücke während der gesamten Chargenlaufzeit konstant bei 1400°C gehalten wird.

7. Verfahren gemäß Anspruch 5 oder 6, **dadurch gekennzeichnet, dass** die Chlorsilanmenge in 15 Stunden auf die Maximalmenge gesteigert wird.

8. Verfahren gemäß Anspruch 5, 6 oder 7, **dadurch gekennzeichnet, dass** der spezifische Mengenstrom an Chlorsilane im Bereich 400 bis 1000 bevorzugt 500 kg Chlorsilane pro h pro m² Siliciumfilamentstabfläche beträgt.

## Claims

1. Polycrystalline silicon rod, **characterized in that** it possesses a rod cross section with an areal proportion of 50-99% silicon available for electrical conduction and the rod has a flexural strength of 0.1 to 80 N/mm².

2. Silicon rod according to Claim 1, **characterized in that** it has a compressive strength of 1 to 100 N/mm² and an apparent density in the range of 2.0 to 2.3 g/cm³ and a total porosity of 0.01 to 0.2.

3. Silicon rod according to Claim 1 or 2, **characterized in that** it has a silicon layer with a homogeneous structure grown on in the Siemens process, which structure comprises pores, seams, gaps, cracks and fissures.

4. Polysilicon fragments, produced from a silicon rod according to Claim 1, 2 or 3, with a fragment size distribution from 1 to 150 mm and a sphericity of 0.7 to 1.0 and a width to length ratio in the range of 0.7 to 1.0, **characterized in that** it has a surface with a total of metallic impurities between 1 and 12 ppbw and the surface has less than 62 ppb of nitrate and less than 1 ppb of fluoride.

5. Process for producing a polysilicon rod according to any of Claims 1 to 3, in which a stream of a reaction gas comprising a chlorosilane mixture and hydrogen is introduced into a reactor and high-purity polysilicon is deposited on a filament rod of silicon heated by direct passage of current, the filament rod being formed from two vertical rods and one horizontal rod, and the horizontal rod forming a linking bridge between the vertical rods, **characterized in that** the chlorosilane mixture used is a mixture of di- and trichlorosilane and the passage of current through the filament rod is regulated such that the filament rod has a temperature at the underside of the bridge between 1300 and 1413°C and the temperature of the reaction gases measured in the reactor is adjusted so as to be not more than 650°C, and the flow rate of the chlorosilane mixture is adjusted to its maximum value within less than 30 hours, preferably within less than 5 hours, from the start of supply of the chlorosilane mixture.

6. Process according to Claim 5, **characterized in that** the temperature at the underside of the bridge over the entire batch run time is kept constant at 1400°C.

7. Process according to Claim 5 or 6, **characterized in that** the chlorosilane rate is increased to the maximum rate within 15 hours.

8. Process according to Claim 5, 6 or 7, **characterized in that** the specific flow rate of chlorosilanes is in the range of 400 to 1000 kg, preferably 500 kg, of chlorosilanes per h per m² of silicon filament rod area.

## Revendications

1. Barre de silicium polycristallin, **caractérisée en ce qu'**elle présente une section transversale de barre ayant une proportion de surface disponible pour la conduction électrique de 50 - 99 % de silicium et la barre présente une résistance à la flexion de 0,1 à 80 N/mm².

2. Barre de silicium selon la revendication 1, **caractérisée en ce qu'**elle a une résistance à la compression de 1 à 100 N/mm² et une densité apparente dans la plage de 2,0 à 2,3 g/cm³ et une porosité totale de 0,01 à 0,2.

3. Barre de silicium selon la revendication 1 ou 2, **caractérisée en ce qu'**elle présente une couche de silicium ayant une structure homogène, déposée dans le procédé Siemens, cette structure comportant des pores, des joints, des interstices, des fissures et des dislocations.

4. Éclat de polysilicium, produit à partir d'une barre de silicium selon la revendication 1, 2 ou 3, ayant une distribution de taille d'éclat de 1 à 150 mm et une sphéricité de 0,7 à 1,0 et un rapport de largeur à longueur dans la plage de 0,7 à 1,0, **caractérisé en ce qu'**il a une surface ayant une somme d'impuretés métalliques comprise entre 1 et 12 ppb en poids et la surface comporte moins de 62 ppb de nitrate et moins de 1 ppb de fluorure.

5. Procédé pour la production d'une barre de polysilicium selon l'une quelconque des revendications 1 à 3, dans lequel on fait passer dans un réacteur un flux quantitatif d'un gaz de réaction contenant un mélange de chlorosilanes et de l'hydrogène et du polysilicium très pur est déposé sur une barre filamentaire de silicium chauffée par passage direct de courant, la barre filamentaire étant constituée de deux barres verticales et d'une barre horizontale et la barre horizontale formant un pont de liaison entre les barres verticales, **caractérisé en ce qu'**on utilise comme mélange de chlorosilanes un mélange de di- et trichlorosilane et le passage du courant dans la barre filamentaire est réglé de manière à ce que la barre filamentaire présente une température à la face inférieure du pont comprise entre 1 300 et 1 413 °C et on mesure et on règle la température des gaz de réaction dans le réacteur de manière à ce qu'elle soit au maximum de 650 °C, et on porte à sa valeur maximale le flux quantitatif du mélange de chlorosilanes en moins de 30 heures, de préférence en moins de 5 heures à partir du début de l'introduction du mélange de chlorosilanes.

6. Procédé selon la revendication 5, **caractérisé en ce que** la température à la face inférieure du pont est maintenue constante à 1 400°C pendant tout le temps du processus de charge.

7. Procédé selon la revendication 5 ou 6, **caractérisé en ce qu'**on augmente la quantité de chlorosilanes en 15 heures jusqu'à la quantité maximale.

8. Procédé selon la revendication 5, 6 ou 7, **caractérisé en ce que** le flux quantitatif spécifique de chlorosilanes est dans la plage de 400 à 1 000, de préférence de 500 kg de chlorosilanes par h par m² de surface de la barre de filament de silicium.
